Europäisches Patentamt

European Patent Office

Office européen des brevets

(19)

(11) EP 1 175 012 A2

(12) **EUROPEAN PATENT APPLICATION**

(43) Date of publication:
23.01.2002 Bulletin 2002/04

(51) Int Cl.$^7$: H03M 13/21

(21) Application number: 01116455.5

(22) Date of filing: 06.07.2001

| | |
|---|---|
| (84) Designated Contracting States:<br>AT BE CH CY DE DK ES FI FR GB GR IE IT LI LU<br>MC NL PT SE TR<br>Designated Extension States:<br>AL LT LV MK RO SI | (72) Inventors:<br>• Linsky, Stuart T.<br>Rancho Palos Verdes CA 90275 (US)<br>• Berger, Harvey L.<br>Redondo Beach, CA 90278 (US) |
| (30) Priority: 19.07.2000 US 619428 | (74) Representative: Schmidt, Steffen J., Dipl.-Ing.<br>Wuesthoff & Wuesthoff, Patent- und<br>Rechtsanwälte, Schweigerstrasse 2<br>81541 München (DE) |
| (71) Applicant: TRW Inc.<br>Redondo Beach, California 90278 (US) | |

(54) **Method and apparatus for error correction decoding a nordstrom-robinson encoded data stream**

(57) A method and apparatus are provided for decoding a received data block encoded with a Nordstrom-Robinson codeword. The method and apparatus reduce the number of mathematical operations necessary to decode the data block. The method and apparatus divide the received data block 600 into subsets 601-604 and calculate a maximum confidence quadracodeword (QCW) character for each data subset 601-604 to form a set of maximum confidence QCW characters (step 304). A set of maximum confidence quadracodewords 802-809 is determined based on the set of maximum confidence QCW characters (step 306). At least one NR codeword 1102 is identified that corresponds to each maximum confidence quadracodeword 802-809 in the set of maximum confidence quadracodewords to thereby form a set of NR codewords (step 308). A single NR codeword is then selected from the set of NR codewords and then used to decode the received data block.

Figure 2

**Description**

BACKGROUND OF THE INVENTION

The present invention generally relates to an error detection and correction decoder and to a communications system for using such an error detection and correction decoder. More specifically, the preferred embodiments of the present invention generally relate to an error detection and correction decoder for a Nordstrom-Robinson encoded data stream.

Communications systems, such as terrestrial and satellite communications systems, have been proposed for passing information data between source and destination terminals via an intermediate receiver, such as a terrestrial tower, a satellite and the like. The information data, such as voice, audio, video, and the like, is encoded with an error detection and correction code before transmission to reduce the influence of transmission path errors. The errors may appear in the received signal as noise and the like. Decoders exist for detecting and correcting errors within the received signal.

In general, error detection and correction encoders add redundancy code bits to the digital information data bit string. The combined information and code data bits are organized into data blocks or symbols. The length of the blocks are determined by the code. As more error correction code bits are added to each data block conveyed over the transmission path, the error detection and correction capability of the system improves. Hence, heavily coded data streams are able to correct more errors in a data block than lightly coded data streams. However, as the error correction codes increase in size, the system requires additional decoder hardware, computing power and computing time to detect and correct the errors.

It may be preferable to use as much error detection and correction coding as possible to enable the communications signals to be transmitted at very low power. As the transmission power decreases, the potential for errors increases. Hence, by encoding the signals, the errors are detectable and correctable and the system demands low transmission power.

A fundamental system tradeoff is required between the transmission power demands and amount of error detection and correction coding necessary to support the power limits. It is desirable to minimize the power requirements of the system. Transmission power is reduced by utilizing an error detection and correction code capable of correcting multiple errors. As the capability of the error code increases, the receivers decoder complexity similarly increases. The complexity of a decoder is generally defined based upon the number of arithmetic operations required to decode a received message. Hence, a balance must be maintained between minimizing system power requirements and limiting the decoder complexity.

Decoders can operate upon either binary of "analog" incoming information signals, namely signals having more than two states (i.e., a non-binary signal). Information signals having more than two possible states are called "soft decisions". Information signals that carry data blocks or symbols having only two states (binary) are called "hard decisions". Each data value is transmitted at one of two discrete voltages, such as a positive voltage corresponding to a +1 or a negative voltage corresponding to a -1. However, the received voltages may vary over a continuum from the maximum positive and negatively transmitted voltages. Hence, the received voltages may no longer correspond identically to +1 or-1. In some decoders, the detected signal may be quantized to one of a limited number of discrete levels. Each level represents a likelihood that a detected signal corresponds to a 1 or 0 bit value. For instance, if the voltage range for incoming signals is $^+$10V to $^-$10V for 1 and 0 bit values, then a quantized detected signal of $^+$8V is more likely to correspond to a one bit level than a quantized detected signal of $^+$2V. A $^-$6V signal is likely to correspond to a zero bit value, rather than a one bit value.

In general, soft decision decoders are generally more complex than hard decision decoders. As the efficiency of the soft decision decoder is improved, the soft decision decoder enables the system to support lower transmission power, while also reducing the complexity of the decoder.

One type of known code is a Nordstrom-Robinson (NR) code. The NR code represents a non-linear binary code, $N_{16}$, consisting of 256 codewords of length 16 bits, such that any two codewords differ in at least six of the 16 bit locations. The NR code is described more fully in "An Optimum Nonlinear Code," Inf. Contr., Vol. 11, pp. 613-616, 1968, by A.W. Nordstrom and J.P. Robinson. A new construction of the Nordstrom-Robinson code was described as the union of the binary images of two isomorphic linear (4, 2, 3) codes over GF(4), by A. Vardy, "The Nordstrom-Robinson Code: Representation over GF(4) and Efficient Decoding," IEEE Transactions on Information Theory, Vol. 40, No. 5, pp. 4686-4693, September 1994. One known technique for decoding an NR code is referred to as maximum likelihood decoding. Another known technique for decoding an NR code is described in the Vardy, et al. article.

However, the Maximum Likelihood and Vardy's decoding techniques require 256 and 205 real operations, respectively, in order to decode a NR encoded data block. Each real operation involves a multiplication, addition or comparison of two values. Thus, existing decoding techniques are overly burdensome on the system hardware, processing ability, etc.

A need remains for an improved decoder that balances the above-noted design considerations. It is an object of the preferred embodiments of the present invention to meet these needs.

BRIEF SUMMARY OF THE INVENTION

A method and apparatus are provided in accordance with a preferred embodiment of the present invention for decoding a received data block encoded with a Nordstrom-Robinson (NR) codeword. The method comprises dividing a received data block into data subsets and calculating a maximum confidence quadracodeword (QCW) character for each data subset to form a set of maximum confidence QCW characters. The method further includes determining a set of maximum confidence quadracodewords based on said set of maximum confidence QCW characters and identifying at least one NR codeword corresponding to each quadracodeword in said set of maximum confidence quadracodewords to form a set of maximum confidence NR codewords. A single NR codeword is selected from said set of maximum confidence NR codewords to decode the received data block. During the calculating step, at least one unique character bit string is mapped to each QCW character and a dot product is obtained of each data subset and each character bit string. The dot products are compared to identify a maximum confidence character representing the QCW character most likely to correspond to the data subset. The method may also include determining correlation weights between one data subset and at least two quadracodeword characters and selecting the quadracodeword character having a maximum correlation weight to be a member of the set of QCW characters.

According to an alternative embodiment, a maximum confidence QCW character may be chosen for a data subset, wherein the maximum confidence QCW character has a maximum correlation to the data subset.

According to another alternative embodiment, a 4x4 soft-decision matrix may be formed from analog data values in the received data block. Each column of the 4x4 soft decision matrix is selected as one of the data subsets.

According to yet another embodiment, multiple pairs of characters may be selected from the set of characteristics. For each character pair, a unique corresponding quadracodeword is identified to form the set of quadracodewords. An apparatus according to one embodiment of the present invention includes a decoder for decoding a data block encoded with a Nordstrom-Robinson (NR) codeword. The decoder includes memory for storing at least one data block divided into data subsets. An arithmatic logic unit calculates a quadracodeword (QCW) character for each data subset to form a set of QCW characters. The arithmatic logic unit (ALU) determines a set of quadracodewords based on the set of calculated QCW characters. The ALU identifies at least one NR codeword corresponding to each quadracodeword in the set of quadracodewords to form a set of NR codewords. The ALU selects an NR codeword from the set of quadracodewords to decode the data block. A character interpretation map maps at least one unique character bit string to each QCW character. The ALU obtains a dot product of each data subset and each character bit string and compares the dot products to identify a maximum confidence character representing the QCW character most likely to correspond to the data subset. The ALU determines correlation weights between one data subset and at least two quadracodeword characters and selects the quadracodeword character having a maximum correlation weight to be a member of the set of QCW characters. The ALU chooses a maximum confidence QCW character for a data set, wherein the maximum confidence QCW character has a maximum correlation to the data set. Memory stores a 4x4 soft decision matrix of analog data values in the received data block. The columns of the 4x4 soft decision matrix represents the data subsets.

According to one embodiment, the ALU selects at least one subset of characters from the set of characters and identifies the unique quadracodeword corresponding to the subset of characters. Memory stores a quadracodeword table listing all even and all available quadracodewords. The ALU identifies the set of quadracodewords from the QCW table based on pairs of characters from the set of characters determined by the ALU.

BRIEF DESCRIPTION OF THE DRAWINGS

Fig. 1 illustrates a block diagram of a communications system in accordance with the preferred embodiment of the present invention.

Fig. 2 illustrates an encoding/decoding processing sequence carried out in accordance with a preferred embodiment of the present invention.

Fig. 3 illustrates a processing sequence carried out by a decoder in accordance with a preferred embodiment of the present invention.

Fig. 4 illustrates a quadracodeword table utilized in connection with a preferred embodiment of the present invention.

Fig. 5 illustrates a character interpretation map utilized in accordance with a preferred embodiment of the present invention.

Fig. 6 illustrates a soft decision matrix utilized in accordance with a preferred embodiment of the present invention.

Fig. 7 illustrates a maximum confidence character table generated in accordance with a preferred embodiment of the present invention.

Fig. 8 illustrates a maximum confidence quadracodeword table generated in accordance with a preferred embodiment of the present invention.

Fig. 9 illustrates a maximum confidence quadracodeword binary interpretation map utilized in accordance with a preferred embodiment of the present invention.

Fig. 10 illustrates a pictorial representation of a processing sequence for identifying NR codewords carried out in connection with a preferred embodiment of the present invention.

Fig. 11 illustrates an NR codeword table generated in accordance with a preferred embodiment of the present invention.

Fig. 12 illustrates a processing sequence for identifying NR codewords carried out in accordance with a preferred embodiment of the present invention.

Fig. 13 illustrates a block diagram of an NR decoder in accordance with a preferred embodiment of the present invention.

DETAILED DESCRIPTION OF THE INVENTION

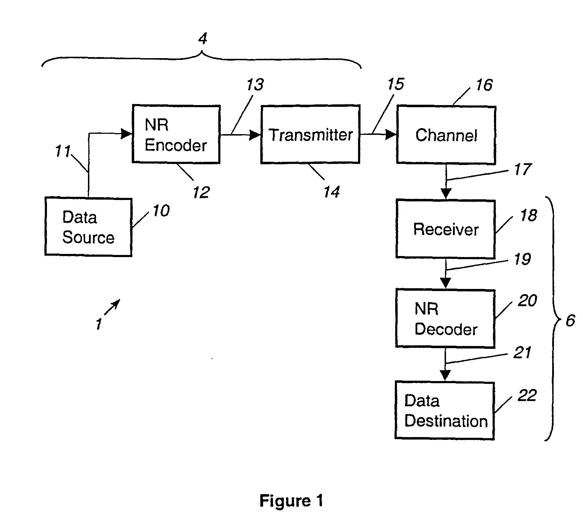

Figure 1 illustrates a general block diagram of a satellite or terrestrial communications system 1 implemented in accordance with a preferred embodiment of the present invention. The system includes first and second terminals 4 and 6 that communicate with one another through a satellite, terrestrial tower, a hardwired land-line and the like (generally referred to as channel 16). Alternatively, the intermediate channel 16 may include an internet connection and the like. The first terminal 4 includes a data source 10 for producing a binary data stream 11 containing information to be transmitted a data destination 22. The data source 10 provides a data stream 11 to a Nordstrom-Robinson encoder 12. The data stream 11 is organized into data sets or blocks (e.g., 8, 16, 32, 64 bit sets) by the source 10 or NR encoder 12. The Nordstrom-Robinson encoder 12 encodes the incoming data stream 11 of information bits to produce encoded data blocks 13. The encoded data blocks 13 are passed to a transmitter 14 that transmits the encoded data signal 15 over a channel 16 to second terminal 6 having a receiver 18. The receiver 18 may be located at a satellite or terrestrial tower as well as at a terminal or ground station. Similarly, the transmitter 14 may be located at a satellite or tower, or at a user terminal or ground station. The first and second terminals 4 and 6 may be hand-held mobile units, fixed units, ground stations, gateways, satellite receivers, internet terminals, PC and the like.

In general, channels 16 experience interference and other phenomena which introduce noise into the transmitted encoded signal to form a data/noise signal 17 received by the receiver 18. Received data blocks 19 are passed from the receiver 18 to a Nordstrom-Robinson decoder 20 which extracts the data stream of information data from the received data blocks 19. The Nordstrom-Robinson decoder 20 outputs an error corrected data stream 21 to a data destination 22.

The structure of the Nordstrom-Robinson decoder 20 and the steps carried out by the Nordstrom-Robinson decoder 20 are explained in more detail below, beginning with a general description of the processing steps and followed by a detailed explanation of exemplary Nordstrom-Robinson decoding implementations.

One approach to decode various types of codes involves finite field arithmetic and the use of codewords. An exemplary finite field is the Galois field (designated GF(q)) that is a finite set of q elements for which specific arithmetic rules apply. The q elements of the Galois field are also referred to as "characters." By way of example, when q=4, the Galois field has four characters. For a quadracode, a group of four characters from GF(4) form each quadracodeword. For instance, if the four characters are (a), (b), (c) and (d), then exemplary codewords may be aaaa, abcd, abac, etc. These codewords are referred to as quadracodewords (QCWs). The location in which the characters appear in a codeword may also be referred to as the position of the characters. In the codeword abca, the character(a) appears in the first and fourth positions, while the characters(b) and (c) appear in the second and third positions respectively. Each character is mapped to two unique four bit binary sets. For instance, the first character(a) may be mapped to 0000 and 1111.

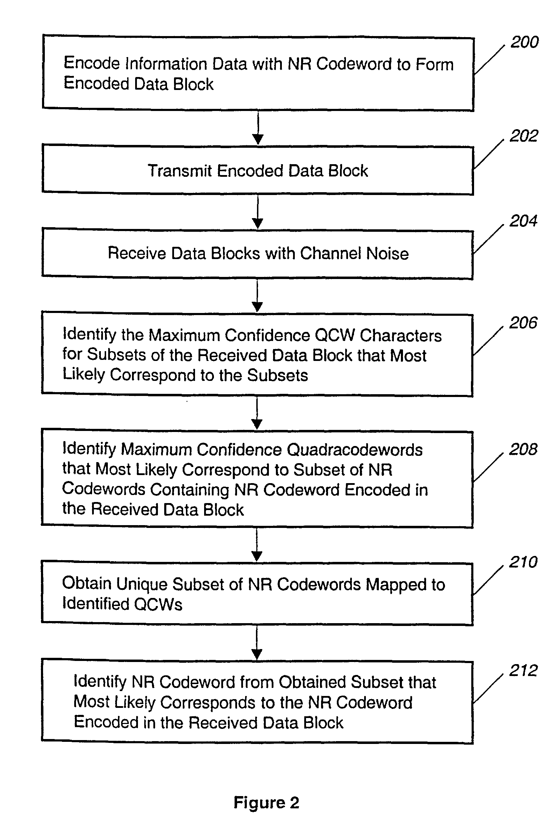

A preferred embodiment of the present invention performs decoding based on a GF(4) finite field. For example, up to 256 Nordstrom-Robinson codewords may be used, from which one codeword is chosen to encode the information data at step 200 of Figure 2. As a further example, 32 quadracodewords may be chosen to map the NR codewords onto the received data block. If 32 QCWs are used then each quadracodeword is mapped to a unique set of eight NR codewords. According to a preferred embodiment of the present invention, the NR decoder 20 first chooses a set of characters most likely to correspond to the received data block 19. Then the NR decoder 20 chooses a set of QCWs most likely to correspond to the set of chosen characters. From the chosen set of QCWs, the NR decoder 20 then chooses a set of NR codewords most likely to correspond to the received data block 19, and then the most likely NR codeword.

Figure 2 illustrates the processing sequence carried out by the system 1 in accordance with a preferred embodiment of the present invention. Beginning at step 200, the NR encoder 12 encodes data blocks in the data stream 11 with Nordstrom-Robinson codewords to form encoded data blocks 13. Each encoded data block 13 is transmitted at step 202 by the transmitter 14 as a transmitted encoded data block 15. During transmission, the transmitted encoded data block 15 experiences interference and other phenomena within the channel 16 that adds noise to the transmitted signal. Hence, the data/noise signal 17 received by the receiver 18 at step 204 does not correspond identically to the transmitted encoded data blocks 15. Each received data block 19 may comprise a plurality of analog values (soft decisions) that range over a continuum between predefined maximum and minimum values. Each soft decision in a received data block 19 corresponds to a bit in the transmitted encoded data block 15.

The errors in the received data blocks 19 are correctable by the Nordstrom-Robinson decoder 20 provided that the number of errors does not exceed the correction capability of the NR decoder 20.

Steps 206-212 generally recite the processing sequence carried out by the Nordstrom-Robinson decoder 20 in order to detect and correct errors within the received data block 19. At step 206, the Nordstrom-Robinson decoder 20 divides the received data block into subsets of soft decisions that are organized in a matrix. The soft decisions may range over the full analog continuum between maximum and minimum values, or may be quantized to discrete levels. The subsets may correspond to rows or columns of the matrix. The NR decoder 20 identifies the "maximum confidence quadracodeword character" for each subset of soft decisions. The maximum confidence quadracodeword character for each subset of the received data block corresponds to a bit string, for which a high probability exists that the bit string closely correlates to the subset of binary values from the transmitted encoded data block 19. At step 208, the NR decoder 20 identifies a set of maximum confidence quadracodewords (QCWs), for which a high probability exists that one of the quadracodewords is mapped to the Nordstrom-Robinson codeword used to encode the information data at step 200. Each quadracodeword is mapped to a unique subset of Nordstrom-Robinson codewords. At step 208, the maximum confidence quadracodewords are identified from the set of all possible quadracodewords. In the present example, eight maximum confidence (MC) quadracodewords (QCW) may be chosen from a total of 32 available quadracodewords. Each of the 8 MC QCWs is mapped to a unique maximum confidence Nordstrom-Robinson (MC NR) codeword (step 210). At step 212, the 8 maximum confidence Nordstrom-Robinson codewords are compared with the received data block 19 to identify the individual Nordstrom-Robinson codeword that most likely corresponds to the codeword used to encode the information data at step 200.

Once the Nordstrom-Robinson codeword is identified at step 212, the NR decoder 20 outputs the identified Nordstrom-Robinson codeword 21 as the error corrected decoded data block 21 corresponding to the received data block 19.

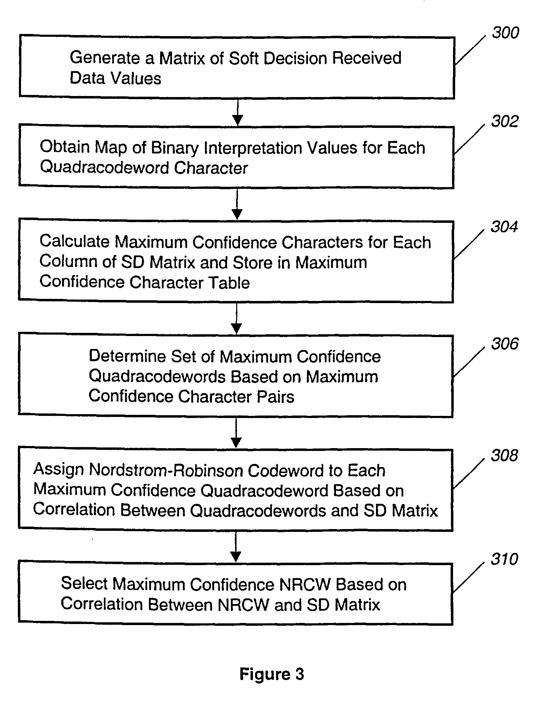

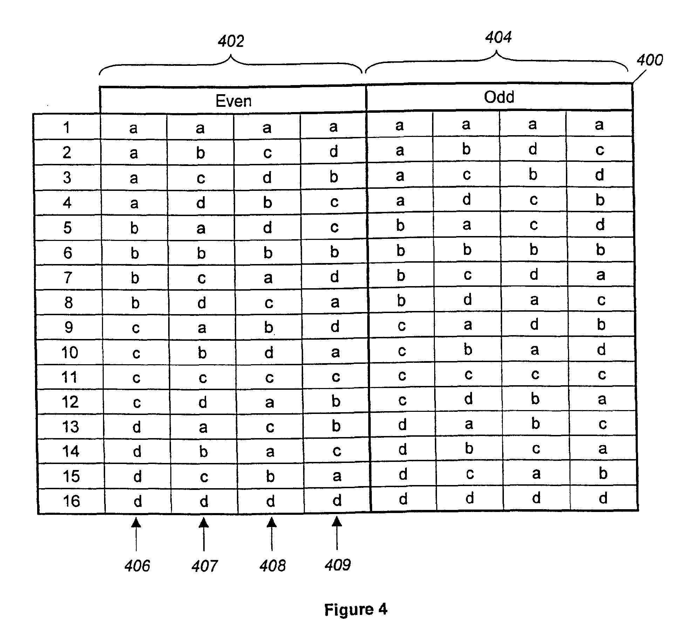

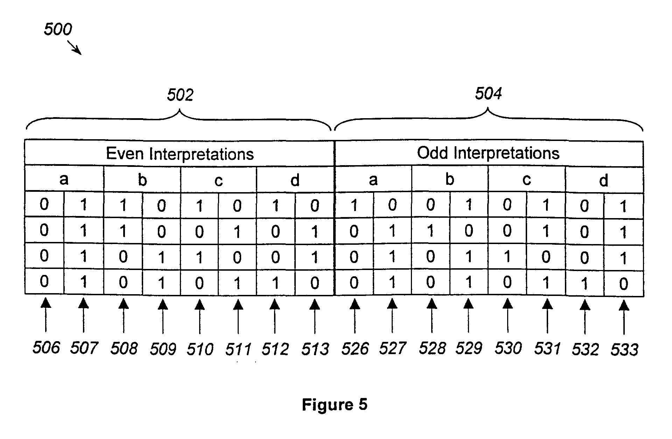

Figure 3 illustrates a more detailed explanation of the processing steps 206-212 of Figure 2. The steps of Figure 3 will be described in connection with the tables illustrates in Figures 4-8. Figures 4 and 5 illustrate tables which are predefined and may be stored as look-up tables in the NR decoder 20 or elsewhere in the system 1. Figure 4 illustrates an exemplary quadracodeword table 400 containing all of the quadracodeword members associated with a GF(4) finite field. The table of Figure 4 contains a total of 32 quadracodewords divided into two groups of 16 quadracodewords (even section 402 and odd section 404). The even section 402 of the quadracodeword table 400 is divided into four columns 406-409. The columns 406-409 correspond to the four positions within the quadracodewords. Each position of a quadracodeword may contain any one of characters(a), (b), (c) or (d). The quadracodeword table 400 represents fewer than all possible combinations of the characters(a), (b), (c) (d).

In the example of Figure 4, each quadracodeword includes four characters, namely character(a), character (b), character(c) and character(d) arranged in various predetermined orders.

Figure 5 illustrates a character interpretation map 500 mapping characters(a)-(d) to unique binary character bit strings 506-513 and 526-533. The character bit strings are defined by the columns of the map. The character map 500 includes even and odd parity sections 502 and 504. Each character bit string 506-513 in the even section 502 has even parity, while each character bit string 526-533 in the odd section 504 has odd parity. Each character is mapped to a pair of character bit strings 506-513 and 526-533. The character bit strings in each pair represent complements of one another. In the example of Figure 5, the even section 502 for character(a) may be mapped to two different character bit string interpretations, namely one including four zeros (denoted character bit string 506) or one including four ones (denoted character bit string 508). The odd interpretation section 504 for the character(a) may be mapped to one of two character bit strings (1, 0, 0, 0) 526 or (0, 1, 1, 1) 527. As a further example, character(c) within the even interpretation section 502 may be mapped to character bit strings (1, 0, 1, 0) 510 or (0, 1, 0, 1) 511.

Each QCW shown in Figure 4 corresponds to eight Nordstrom-Robinson codewords, such that the 16 even QCWs correspond to 128 NR codewords, and the 16 odd QCWs correspond to 128 NR codewords. The union of even and odd QCWs correspond to all $2^8 = 256$ NR codewords. Each character in Figure 4 corresponds to any of the two interpretations shown in Figure 5. However, when the binary interpretations of a QCW are arranged in 4 x 4 matrix, the set of interpretations must be selected so the top raw of the matrix most have even polarity for QCWs in rows 1, 6, 11 and 16 of the even QCWs and odd polarity for QCWs in the remaining even QCWs. Similarly, the set of interpretations must be selected so the top raw of the matrix must have odd polarity for QCWs in rows 1, 6, 11 and 16 of the odd QCWs and even polarity in the remaining odd QCWs. Hence, while there are 512 possible binary interpretations of the 32 quadracodewords, only 256 of the 512 correspond to Nordstrom-Robinson codewords.

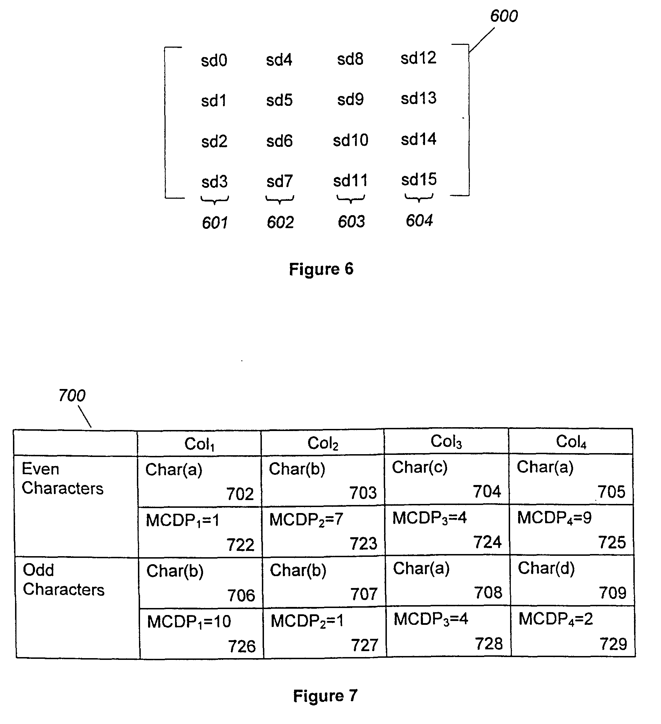

Returning to Figure 3, at step 300, the NR decoder 20 constructs a matrix from the received data values. By way of example only, the received data block 19 may include 16 soft decisions that are organized into a 4x4 matrix 600 as illustrated in Figure 6. The columns 601-604 of the matrix 600 are analyzed as subsets, as described below. The elements of the soft decision matrix 600 are denoted by descriptors sd0-sd15 indicating the order in which the soft decision values were received.

At step 302, the character interpretation map 500 (Fig. 5) is obtained and utilized as explained below to identify character bit strings for individual characters and determine which character bit strings correlate closest to the columns 601-604 of the soft decision matrix 600.

At step 304, the even and odd characters(a)-(d) are compared separately to each column 601-604 to calculate maximum confidence characters for each column. More specifically, one character bit string 506-513 and 523-533 for each even and for each odd character(a)-(d) is multiplied with each column 601-604. The character interpretation map 500 includes two character bit strings (pairs) for each even character and two character bit strings (pairs) for each odd character. However, during step 304, the NR decoder 20 may choose either character bit string from each pair since only the sign of the dot products varies. As a consequence, only the absolute value of the dot product is used in steps 304 and 306. The even and odd characters(a)-(d) are identified that produce the maximum dot product for the even QCW characters and the maximum dot product for the odd QCW characters, respectively, with the column 601-604. For example, the dot product of even character(a) and column 601 may be calculated as follows:

$$CDP^e_{a,1} = ABS(sd_0 * +1)+(sd_1 * +1)+(sd_2 * +1)+(sd_3 * +1).$$

$CDP^e_{a,1}$ represents the absolute value of the dot product of the character bit string 0000 associated with character(a) and the first column 601 of the matrix 600. The NR decoder 20 also calculates the dot product $CDP^e_{b,1}$, $CDP^e_{c,1}$, and $CDP^e_{d,1}$ for the first column 601 and even character(b), the first column 601 and even character(c), and the first column 601 and even character(d),respectively. The absolute value of the four even character dot product values $CDP^e_{a,1}$ - $CDP^e_{d,1}$ are compared to identify the maximum even character (MDP). The character(a), (b), (c), (d) producing the maximum dot product (MDP) is assigned as the "maximum confidence QCW character" for the first column 601.

The foregoing process is repeated for the second column 602 with each of the even characters(a), (b), (c) (d), for the third column 603 with each of the even characters (a)-(d), and for the fourth column 604 with each of the even characters(a)-(d). Thereafter, the NR decoder 20 calculates the correlation between each column 601-605 and the odd characters(a)-(d), that is the odd character bit strings 526 - 533 interpretations for the characters(a)-(d). Hence, at step 304, the NR decoder 20 assigns one maximum confidence even character(a)-(d) and one maximum confidence odd character(a)-(d) to each column 601-604. The same character(a)-(d) may be assigned to more than one column 601-604.

The maximum confidence (MC) even character 702-705 and maximum confidence (MC) odd character 706-709 assigned to each column 601-604 is stored in the Maximum Confidence Character Table 700 (Figure 7). The even and odd MC characters are stored in Table 700 in an order associated with, and defined by, the position of the corresponding column 601-604 in the Matrix 600.

In the example of Figure 7, the first through fourth columns 601-604 are assigned even MC characters (a), (b), (c), (a). The columns 601-604 are assigned odd MC characters(b), (b), (a), (d). The Maximum Confidence Character Table 700 may also store the dot product values 722-729 associated with each even and odd maximum confidence character(a)-(d) 702-709. For instance, in the example of Fig. 7, the Maximum Confidence Character Table 700 stores even character dot product values (1, 7, 4, 9) and odd character dot product values (10, 1, 4, 2).

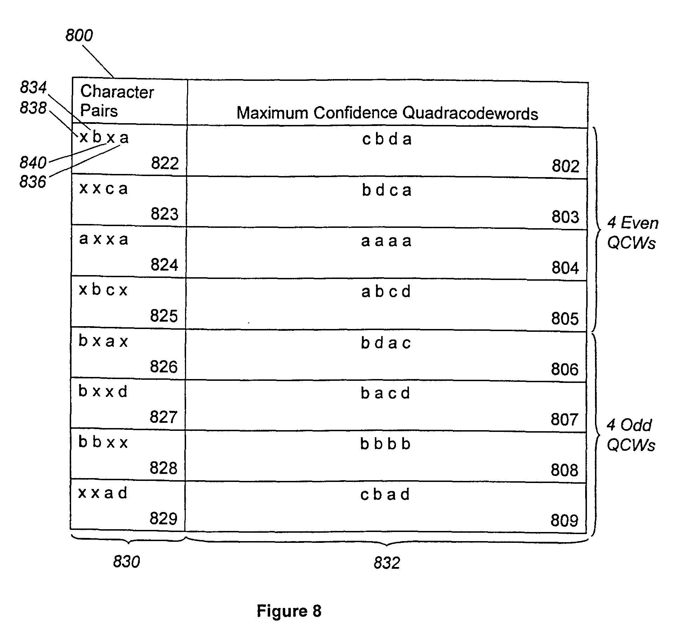

At step 306, the NR decoder 20 next determines a set of maximum confidence quadracodewords (MC QCWs) based on the maximum confidence characters 702-709 of Figure 7. In the implementation of Figure 3, the NR decoder 20 selects pairs of characters from Maximum Confidence Character Table 700 and uses the character pairs to identify complete quadracodewords in the quadracodeword table 400. The operation of step 306 is illustrated in connection with Figure 8.

Figure 8 illustrates a Maximum Confidence Quadracodeword Table 800, in which the decoder 20 stores a subset of quadracodewords 802-809 believed to most likely include the quadracodeword that maps to the Nordstrom-Robinson codeword used to encode the information data. The Maximum Confidence Quadracodeword Table 800 includes character pairs 822-829 in the lefthand column 830 and unique corresponding quadracodewords 802-809 in the right-hand column 832. Each row of the column 830 includes four positions, two of which are filled with maximum confidence characters 834 and 836 chosen by the NR decoder 20 from the Maximum Confidence Character Table 700. The remaining two positions 838 and 840 are open as denoted by the wild-card "x".

The NR decoder 20 chooses character pairs based on the predetermined relative pair weights of dot products 722-729 stored in the Maximum Confidence Character Table 700. For example, the NR decoder may pick, as one character pair, the maximum confidence characters 705 and 703 having the highest and second highest dot products 725 and 723 as the first pair 834, 836 placed in column 830 of table 800.

For instance, character(a) in the fourth position of the Maximum Confidence Character Table 700 has the largest dot product 9 (or maximum likelihood correlation to a column of the matrix 600), while character(b) in the second position has the second largest dot product 7. Hence, the first entry in the character pair column 830 is (x, b, x, a) where the "x" designation indicates that the character is unknown.

Next, the NR decoder 20 accesses Quadracodeword Table 400 to identify an even quadracodeword in section 402 containing the character(b) in the second position and the character(a) in the fourth position. In the even section 402 of the Quadracodeword Table 400, the tenth even quadracodeword (c, b, d, a) represents the only even quadracodeword having the character(b) in the second position and the character(a) in the fourth position. Hence, the quadracodeword (c, b, d, a) 802 is added to the Maximum Confidence Quadracodeword Table 800.

Next, the NR decoder 20 selects the maximum confidence characters 705 and 704 which have the largest and third largest dot products 725 and 724 (character(a) in the fourth position and character(c) in the third position). Returning to the Quadracodeword Table 400, the eighth quadracodeword in the even section 402 includes character (c) in the third position and character(a) in the fourth position. Hence, the quadracodeword (b, d, c, a) 803 is added to the Maximum Confidence Quadracodeword Table 800. The NR decoder repeats the above-noted process for the character pair 705, 702 for the largest and fourth largest dot products 725, 722 (a, x, x, a) and for the character pair 703, 704 having the second and third largest dot products 723, 724 (x, b, c, x). Cross-referencing the character pairs in the third and fourth rows of column 830 with the Quadracodeword Table 400 yield the quadracodewords (a, a, a, a) 804 and (a, b, c, d) 805, respectively.

Step 306 is repeated with respect to the maximum confidence odd characters to obtain four odd quadracodewords. Upon completion of step 306, eight quadracodewords 802-809 (four even and four odd) are identified as potential candidates that map to the Nordstrom-Robinson codeword used to encode the information data.

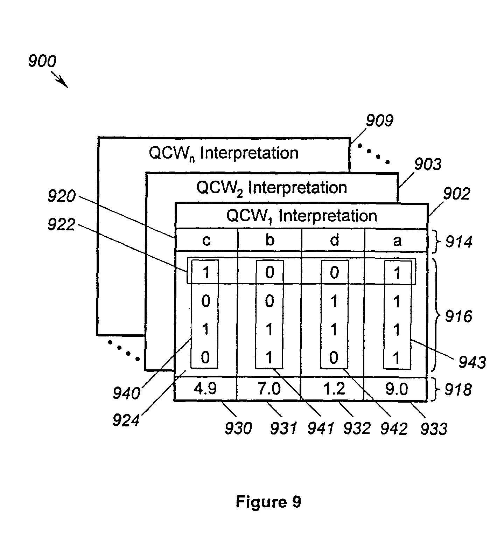

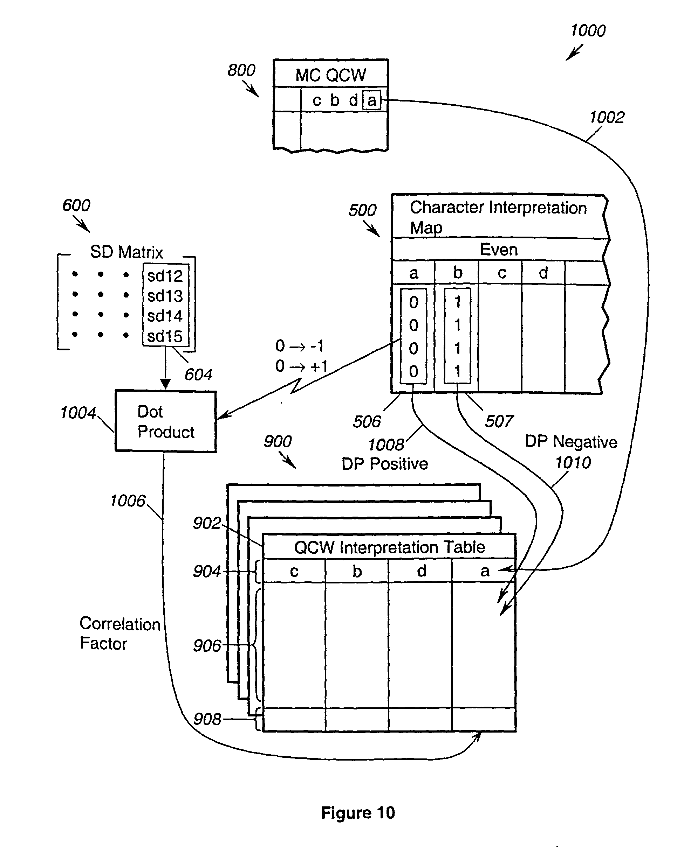

After obtaining the eight maximum confidence quadracodewords 802-809, processing passes to step 308 at which the NR decoder 20 assigns one Nordstrom-Robinson codeword to each quadracodeword 802-809. As explained above, each quadracodeword maps to a unique set of 8 Nordstrom-Robinson codewords. In step 308, the decoder 20 identifies a single Nordstrom-Robinson codeword from each group of eight QCWs that most likely corresponds to the soft decision matrix. In the foregoing manner, the decoder 20 reduces the group of 64 Nordstrom-Robinson codewords mapped to the eight MC quadracodewords 802-809 to a sub-group of eight Nordstrom-Robinson codewords. The steps for identifying one of the eight NR codewords for each MC quadracodeword 802-809 is explained below in more detail in connection with Figs. 9 and 10.

Fig. 9 illustrates a Binary Codeword Interpretation Map 900 that is generated at step 308. The interpretation map 900 include a separate interpretation table 902 for each MC QCWs 802-809. In the example described above, four even MC QCWs 802-805 and four odd MC QCWs 806-809 are calculated, and thus eight interpretation tables 902-909 are created and stored. Each interpretation table 902-909 includes a QCW header 914, a codeword byte 916 and a set of bit string correlation factors 918. The QCW header 904 is loaded from the MC QCWs 802-809 stored in MC QCW Table 800. The codeword byte 916 is formed from a string of multiple codeword bits 940-943. The bit string correlation factors 918 represent the absolute value of the dot product of the related codeword bit string 940-943, and the related column 601-604 of the soft decision matrix 600. The bit string is selected as the interpretation shown in Figure 5 so that the correlation factor is non-negative.

In the example of Fig. 9, the first interpretation table 902 stores the quadracodeword "cbda" corresponding to the first quadracodeword 802 stored in the MC QCW Table 800. Within the interpretation table 902, each column 930-933 is assigned to one character and loaded with a codeword bit string 940-943 chosen from the character interpretation map 500. In the example of Fig. 5, the character bit strings 506, 507 associated with the even interpretation of character(a) corresponds to 0000 and 1111. The decoder 20 selects the character bit string with a 1 in the top row, for instance 507, and compares it with the associated column 604 of the matrix 600 to obtain the dot product of the column 604 and character bit string 507. The decoder 20 stores the character bit string 507 as codeword bit string 943 if the dot product is non-negative. The decoder 20 stores character bit string 506 as codeword bit string 943 if the dot product is negative.

For each of characters(c), (b) and (d), a character bit string from the character bit string pairs (510, 511), (508, 509) and (512, 513) is chosen based upon the sign of the dot product of the arbitrarily chosen character bit string 510, 508 and 512 with a corresponding column 601-603 from the soft decision matrix 600. The pair of character bit strings associated with the two interpretations of a single character, when multiplied by a particular column of the soft decision matrix 600, yield equal correlation factors that are opposite in sign. The character bit string yielding the positive dot product is chosen for each character. Hence, in the example of Fig. 9, the bit string 1010 for character(c) was chosen since the dot product of the bit string 1010 and the soft decisions sd0-sd3 yielded a positive correlation factor (9.0). The converse bit string (0101) would yield a negative 9.0 correlation factor.

The bit string correlation factors 918 represent the absolute values of the dot products. In the example of Fig 9, the bit string correlation factors 918 assigned to the first table 902 are 4.9,7.0, 1.2 and 9.0 for the characters(c), (b), (d), (a), respectively. The bit string correlation factors 918 represent the degree to which each corresponding bit string correlates with the associated column in the soft decision matrix 600. In the example of Fig. 9, the codeword bit string 940 (1010) (corresponding to character(c)) produces a bit string correlation factor of 4.9 when multiplied by the first column 601 of the soft decision matrix 600.

Fig. 10 illustrates an example of the process by which the NR decoder 20 maps a character bit string interpretation to a codeword byte 916. In Fig. 10, a portion of the maximum confidence quadracodeword table 800 is illustrated, including the first MC quadracodeword 802, (cbda). A portion of the character interpretation map 500 is also displayed for the even interpretation section 502 of character(a), including the character bit string pair 506, 507 (0000 and 1111). The fourth column 604 of the soft decision matrix 600 is also illustrated.

During step 308 (Fig. 3), the decoder 20 writes character(a) from the fourth position in the quadracodeword in table 800 to the fourth position in the QCW header 914 in the interpretation table 902 (as denoted by line 1002). Next, the NR decoder 20 arbitrarily chooses character bit string 507. By way of example, the character bit string 507 (1111) is selected and multiplied by the fourth column 604 of the soft decision matrix 600 to obtain a dot product 1004. The dot product 1004 represents a correlation factor that is stored (line 1006) as the bit string correlation factor 918 for character(a). The bit string correlation factor 918 is stored as an absolute value.

If the character bit string 507 (1111) yields a non-negative dot product 1004, then the NR decoder 20 stores the bit string (1111) as the codeword bit string 943 in interpretation table 902 (as indicated by line 1008). Alternatively, if the character bit string 507 (1111) yields a negative dot product, then the NR decoder 20 stores the complementary bit string (0000) as the codeword bit string 943 in the interpretation table 902 (as indicated by line 1010).

The foregoing process is repeated for the characters (c), (b) and (d) from the first quadracodeword 802 in table 800. In particular, one of the bit strings associated with character(c) from map 500 is arbitrarily chosen and multiplied by the soft decisions sd0-sd3 in the first column of the soft decision matrix 600. The absolute value of the dot product is stored in the interpretation table 902. One of bit strings 1010 and 0101 (corresponding to character(c)) is selected based upon the sign of the dot product and stored in the interpretation table 902.

The foregoing process is repeated for each even and odd quadracodeword 802-809 stored in table 800. In the above discussed example, four even and four odd quadracodewords 802-809 are stored in table 800 and thus the map 900 would include eight interpretation tables 902-909.

Next, the interpretations tables 902-909 are analyzed to determine whether the 16 bits comprising each codeword byte 916 correspond to a Nordstrom-Robinson codeword. The decoder 20 analyzes each interpretation table 902 based upon theorem 1 set forth in the Vardy article entitled "The Nordstrom-Robinson Code: Representation Over GF (4) and Efficient Decoding" cited above.

Beginning with the first interpretation table 902, the QCW header 914 is analyzed to determine whether the codeword 920 includes four characters that are the same, namely aaaa, bbbb, cccc or dddd. An even NR codeword comprised of four identical characters has even parity for the first row 922 of the bits in the codeword byte 916. All even NR codewords comprised of four non-identical characters have odd parity for the first row 922 of the bits in the codeword byte 916. Odd NR codewords exhibit a parity characteristic opposite that of the even NR codewords. Odd NR codewords comprised of four identical characters exhibit odd parity in the first row 922 of the codeword byte 916. Odd NR codewords comprised of four non-identical characters exhibit even parity in the first row 922 of the codeword byte 916.

During operation, the NR decoder 20 first determines whether the codeword 920 includes four identical characters. The decoder 20 then determines whether the parity of the top row 922 is even or odd. In the example of Fig. 9, the codeword 920 does not include four identical characters and thus the parity of the first row 922 should be odd. The first row 922 includes bits (1001) which have even parity. Thus, the 16 bit codeword byte 916 illustrated in Fig. 9 does not constitute a Nordstrom-Robinson codeword.

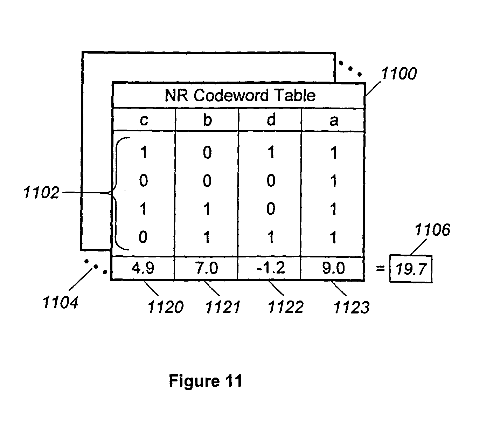

The NR decoder 20 converts the 16 bit codeword byte 916 to a Nordstrom-Robinson codeword by replacing a selected one of the codeword bit strings 940-943 with its complement. The codeword bit string 940-943 having the lowest bit string correlation factor 918 is chosen to be replaced with its complement. In the example of Fig. 9, the third column 932 corresponds to character(d) and has a bit string correlation factor of 1.2. The bit string correlation factor of 1.2 is the lowest bit string correlation factor, and thus the bit string (0110) in column 932 is replaced with its converse (1001) and the signal the correlation factor is negated as illustrated in Fig. 11.

Fig. 11 illustrates a modified interpretation table 1100 for a quadracodeword including the characters(cbda). The 16 bit codeword byte stored in table 1100 includes the bit strings (1010), (0011), (1001) and (1111) which correspond to a Nordstrom-Robinson codeword 1102. The NR correlation factor in column 1122 in Fig. 11 changes, character(d) was inverted, since complementing a bit string changes the correlation factors.

The NR decoder 20 repeats the above process for each interpretation table 902 in the map 900 in order to form a Map of Nordstrom-Robinson codeword tables 1100. The NR decoder 20 next selects the single Nordstrom-Robinson codeword 1102 from the set of tables 1100 that most closely corresponds to the soft decision matrix 600.

The NR decoder 20 selects the NR codeword 1102 associated with the table 1100 having the highest total NR correlation factor 1106. The total NR correlation factor 1106 for each table 1100 is calculated by summing the NR correlation factors 1120-1123 associated with each character in the table 1100. In the example of Fig. 11, the NR correlation factors 4.9, 7.0, -1.2 and 9.0 are summed to obtain an NR codeword correlation factor equal to 19.7. The NR codeword correlation factor 1106 for each table 1100 is calculated, and the table 1100 having the highest NR codeword correlation factor 1106 is selected as the Nordstrom-Robinson codeword most likely to be associated with the soft decision matrix 600. Once the table 1100 having a maximum confidence NR codeword is selected, the NR codeword 1102 therein is used to decode the received data block stored in the soft decision matrix 600.

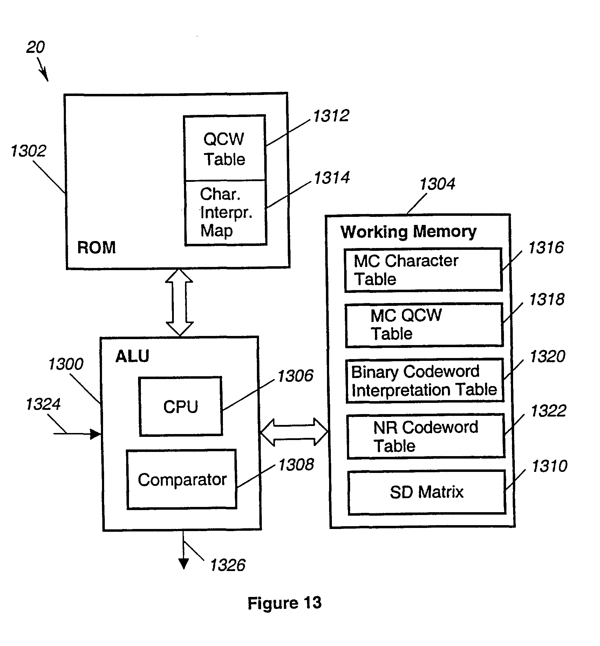

Fig. 13 illustrates an exemplary configuration for the Nordstrom-Robinson decoder 20 in accordance with at least one preferred embodiment of the present invention. The NR decoder 20 includes an arithmatic logic unit 1300 which communicates with a storage medium 1302 and a working memory 1304. The storage medium 1302 may be ROM, EEPROM and the like. The arithmatic logic unit 1300 may include a CPU 1306 and a comparator 1308, that may constitute a single piece of hardware or a combination of hardware. The CPU 1306 and comparator 1308 perform the mathematical operations described above to identify the maximum confidence characters, maximum confidence quadracodewords, codewords, Nordstrom-Robinson codewords and the like. The ALU 1300 also performs the decoding operations to convert a received data block 19 to a decoded information signal 21. The storage medium 1302 includes memory allocated and configured to store a quadracodeword table 1312, and a character interpretation map 1314, examples of which are illustrated in Figs. 4 and 5. The working memory 1304 temporarily stores data while the ALU 1300 performs the Nordstrom-Robinson decoding operation. The working memory 1304 may include memory allocated and configured to store a soft decision matrix 1310, a maximum confidence character table 1316, a maximum confidence quadracodeword table 1318, a binary codeword interpretation table 1320 and Nordstrom-Robinson codewords 1322, examples of which are illustrated in Figs. 6-9 and 11.

It is to be understood that the tables 1316-1322 need not necessarily be stored as discrete structures, but instead, may be simplified to fewer structures. For instance, the NR codeword table 1322 may merely represent a modification of the binary codeword interpretation table 1320, without a new table being stored.

The ALU 1300 receives incoming data blocks on line 1324, stores the received data blocks in the soft decision matrix 1310 and performs processing as described above to calculate a corresponding Nordstrom-Robinson codeword that is used to decode the received data blocks stored in soft decision matrix 1310 and to output a decoded information signal on line 1326.

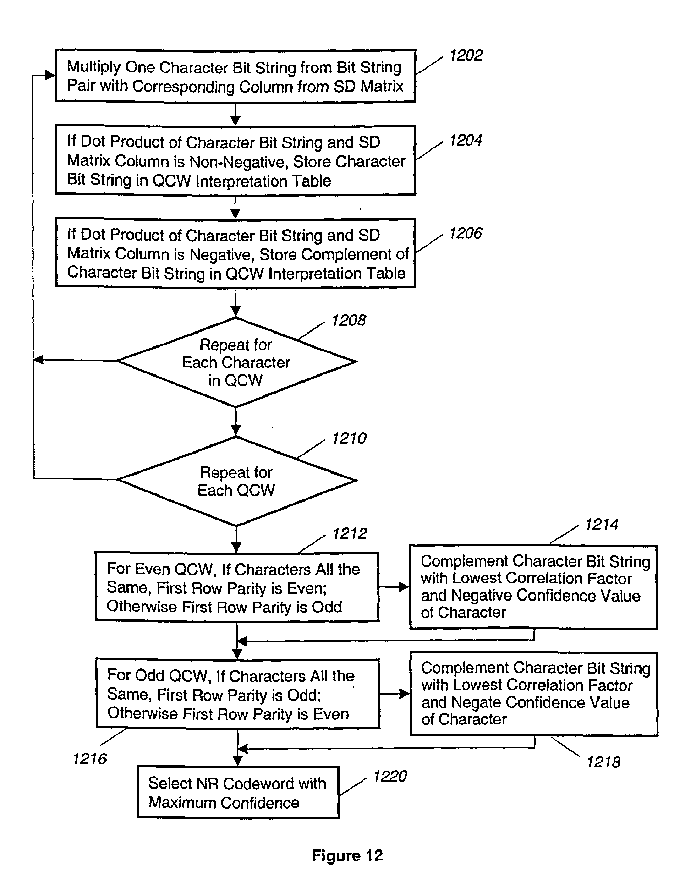

Fig. 12 illustrates a more detailed explanation of the processing sequence carried out by NR decoder 20 of Fig. 13 in connection with steps 308 and 310 of Fig. 3 to identify the NR codeword in accordance with at least one preferred embodiment of the present invention.

At step 1202, the CPU 1306 multiplies one character bit string 506-513 and 526-533 from a bit string pair (obtained from the character interpretation map 500) with a corresponding column 601-604 from the soft decision matrix 600. The sign of the dot product is analyzed. At step 1204, if the dot product sign is non-negative, then the character bit string 506-513 is stored in the binary codeword interpretation table 1320. Alternatively, at step 1206, if the dot product sign is negative, then the converse of the character bit string is stored in the interpretation table 1320.

At step 1208, the CPU 1306 determines whether the currently analyzed character represents the last character in a particular quadracodeword 802. If not, control returns to step 1202. If the quadracodeword analysis is complete at step 1208, processing passes to step 1210, at which the CPU 1306 determines whether all of the quadracodewords in the set of maximum confidence quadracodewords 802-809 have been assigned an interpretation table 1320. If not, flow returns to step 1202. If so, flow passes on to step 1212. In the foregoing manner, steps 1202-1210 generate QCW interpretation tables 1320 for each quadracodeword in the set of maximum confidence QCWs 802-809. Each interpretation table 1329 stores a binary codeword 916.

As noted above, the binary codewords stored in the interpretation tables 902 may not constitute Nordstrom-Robinson codewords. Hence, at steps 1212-1218, the NR decoder 20 analyzes and corrects each interpretation table 1320 to form Nordstrom-Robinson codewords therein.

In more detail at step 1212, the ALU 1300 analyzes the interpretation tables 1320. If the parity for a binary codeword does not satisfy the parity condition set forth in step 1212, the binary codeword does not correspond to an NR codeword. Accordingly, flow passes to step 1214 at which the binary codeword is corrected by complementing the character bit string having the lowest correlation with the soft decision matrix 600. The correlation factors are stored in the interpretation tables 1314 and thus need not be recalculated. Steps 1212 and 1214 are repeated for each even quadracodeword and thereafter flow passes to step 1216.

In step 1216, the NR decoder analyzes the odd quadracodewords for proper parity. For each odd binary codeword that does not satisfy the conditions in step 1216, flow passes to step 1218 at which the binary codeword is corrected to correspond to a Nordstrom-Robinson codeword. Steps 1216 and 1218 are repeated for each odd quadracodeword, after which, processing passes to step 1220. At steps 1212-1218, eight Nordstrom-Robinson codewords are passed to step 1220. At step 1220, the ALU 1300 selects the NR codeword having the maximum correlation to the soft decision matrix. The NR codeword is selected at step 1220 by summing the correlation factors stored in the interpretation table 1320.

A more detailed explanation is set forth in connection with an alternative embodiment. The receiver 18 outputs a block of 16 soft decisions, sd(i), sd=[sd(0), sd(1),...,sd(15)]. The NR decoder 20 arranges the block of 16 soft decisions into a 4x4 array, SD, as follows:

| sd(0) | sd(4) | sd(8) | sd(12) |
| sd(1) | sd(5) | sd(9) | as(13) |
| sd(2) | sd(6) | sd(10) | sd(14) |
| sd(3) | sd(7) | sd(11) | sd(15) |

SD (k,j) = sd (4j+(i mod 4)), k = i mod 4
k=0,...,3,j=0,...3
k is the row index, j is the column index

First, the NR decoder 20 constructs a hard decision array, HD(k,j), by making a decision based on the sign of each entry of the SD matrix. If the sign of SD(k,j) is positive, HD(k,j)=0; otherwise, HD(k,j)=1. Next the NR decoder 20 determines the smallest element (absolute value) of each column of SD matrix, $SD_{min}$(j), and the corresponding row index, $k_{min}$(j). Then the NR decoder 20 computes the maximum character soft decision of each column, $CSD_{max}$(j), by taking the sum of the absolute values of each column and assigning the sign (sgn) of the element in the first row to it:

$$CSD_{max}(j)=SD(0,j)+[sgnSD(0,j \cdot sgnSD(1,j)] \cdot SD(1,j)$$

$$+[sgnSD(0,j) \cdot sgnSD(2,j)] \cdot SD(2,j)$$

$$+[sgnSD(0,j) \cdot sgnSD(3),j)] \cdot SD(3,j)$$

Next, the NR decoder 20 determines the parity of each column of HD, PHD(j), as follows:

$$PHD(j)=HD(0,j) \oplus HD(1,j) \oplus HD(2,j) \oplus HD(3,j)$$

Then the NR decoder 20 computes the maximum even character soft decision of each column and the even hard decision, as well as the maximum odd character soft decision of each column and the odd hard decisions:
If PHD(j)=0:

$$CSD_{e,max}(j) =CSD_{max}(j)$$

$$CSD_{o,max}(j) =CSD_{max}(j) -2 \cdot [sgnSD(o,j) \cdot sgnSD_{min}(j)] \cdot SD_{min}(j)$$

$$HD_e(k,j)=HD(k,J)$$

$$HD_o(k, j) = \begin{cases} \overline{HD(k,j)}, k = k_{min}(j \\ HD(k,j), k \neq k_{min}(j \end{cases}$$

Else if PHD(j)=1:

$$CSD_{o,max}(j) = CSD_{max}(j)$$

$$CSD_{e,max}(j) = CSD_{max}(j) - 2 \cdot [sgnSD(0,j) \cdot sgnSD_{min}(j)] \cdot SD_{min}(j)$$

$$HD_o(k,j) = HD(k,j)$$

$$HD_e(k,j) = \begin{cases} \overline{HD(k,j)}, k = k_{min}(j \\ HD(k,j), k \neq k_{min}(j \end{cases}$$

Then the NR decoder 20 determines the maximum and minimum character soft decisions in the set, $\{CSD_{e,max}(j), j=0,...,3\}$. The NR decoder 20 takes the difference between $CSD_{e,max}(0)$ and $CSD_{e,max}(1)$, then determines the sign:

$$D_e 1 = sgn[CSD_{e,max}(0) - [sgn\ SD(0,0)\ sgnSD(0,1)]CSD_{e,max}(1)]$$

Next the NR decoder 20 determines the maximum and minimum of the two, $Max_e 1$ and $Min_e 1$, respectively according to Table 1 below:

Table 1

| $D_e 1$ | sgnSD(0,0) | $Max_e 1$ | $Min_e 1$ |
|---|---|---|---|
| + | + | $CSD_{e,max}(0)$ | $CSD_{e,max}(1)$ |
| + | - | $CSD_{e,max}(1)$ | $CSD_{e,max}(0)$ |
| - | + | $CSD_{e,max}(1)$ | $CSD_{e,max}(0)$ |
| - | - | $CSD_{e,max}(0)$ | $CSD_{e,max}(1)$ |

The NR decoder 20 takes the difference between $CSD_{e,max}(2)$ and $CSD_{e,max}(3)$, then determines the sign:

$$D_e 2 = sgn[CSD_{e,max}(2) - [sgnSD(0,2) \cdot sgnSD(0,3)] \cdot CSD_{e,max}(3)]$$

Then the NR decoder 20 determines the maximum and minimum of the two, $Max_e 2$ and $Min_e 2$, respectively, according to Table 2 below:

Table 2

| $D_e 2$ | sgnSD(0,2) | $Max_e 2$ | $Min_e 2$ |
|---|---|---|---|
| + | + | $CSD_{e,max}(2)$ | $CSD_{e,max}(3)$ |
| + | - | $CSD_{e,max}(3)$ | $CSD_{e,max}(2)$ |
| - | + | $CSD_{e,max}(3)$ | $CSD_{e,max}(2)$ |
| - | - | $CSD_{e,max}(2)$ | $CSD_{e,max}(3)$ |

Then the NR decoder 20 takes the difference between $Max_e 1$ and $Max_e 2$, then determines the sign:

$$D_e 3 = sgn[Max_e 1 - [sgnMax_e 1 \cdot sgnMax_e 2] \cdot Max_e 2]$$

The sign of $D_e 3$ will determine the maximum $CSD_{e,max}(j)$, $Max_e$, according to Table 3 below:

Table 3

| $D_e3$ | sgnMax$_e$1 | Max$_e$ |
|---|---|---|
| + | + | Max$_e$1 |
| + | - | Max$_e$2 |
| - | + | Max$_e$2 |
| - | - | Max$_e$1 |

The NR decoder 20 takes the difference between Min$_e$1 and Min$_e$2, then determines the sign:

$$D_e4 = \mathrm{sgn}\,[Min_e1 - [sgnMin_e1 \cdot sgnMin_e2] \cdot Min_e2]$$

The sign of $D_e4$ will determine the minimum $CSD_{e,max}(j)$, Min$_e$, according to Table 4 below:

Table 4

| $D_e4$ | sgnMin$_e$1 | Min$_e$ |
|---|---|---|
| + | + | Min$_e$2 |
| + | - | Min$_e$1 |
| - | + | Min$_e$1 |
| - | - | Min$_e$2 |

Max$_e$ and Min$_e$ are the maximum and minimum character soft decisions of the set $\{CSD_{e,max}(j), j=0,...,3\}$. The column indices of these maximum and minimum character soft decisions, $j_{e,max}$ and $j_{e,min}$, indicate the positions of Max$_e$ and Min$_e$. The column indices, $j_{e,2}$ and $j_{e,3}$, indicate the positions of the remaining two character soft decisions.

Next the NR decoder 20 determines the maximum and minimum character soft decisions in the set $\{CSD_{o,max}(j), j=0,...3\}$. The difference is calculated between $CSD_{o,max}(0)$ and $CSD_{o,max}(1)$, then the sign is determined:

$$D_o1 = \mathrm{sgn}[CSD_{o,max}(0) - [sgnSD(0,0) \cdot sgnSD(0,1)] \cdot CSD_{o,max}(1)]$$

The maximum and minimum are determined of the two, Max$_o$1 and Min$_o$1, respectively, according to Table 5 below:

Table 5

| $D_o1$ | sgnSD(0,0) | Max$_o$1 | Min$_o$1 |
|---|---|---|---|
| + | + | $CSD_{o,max}(0)$ | $CSD_{o,max}(1)$ |
| + | - | $CSD_{o,max}(1)$ | $CSD_{o,max}(0)$ |
| - | + | $CSD_{o,max}(1)$ | $CSD_{o,max}(0)$ |
| - | - | $CSD_{o,max}(0)$ | $CSD_{o,max}(1)$ |

The difference is taken between $CSD_{o,max}(2)$ and $CSD_{o,max}(3)$, then the sign is determined:

$$D_o2 = \mathrm{sgn}[CSD_{o,max}(2) - [sgnSD(0,2) \cdot sgnSD(0,3)] \cdot CSD_{o,max}(3)]$$

Next, the NR decoder 20 determines the maximum and minimum of the two, Max$_o$2 and Min$_o$2, respectively according to Table 6 below:

Table 6

| $D_o2$ | sgnSD(0,2) | $Max_o2$ | $Min_o2$ |
|---|---|---|---|
| + | + | $CSD_{o,max}(2)$ | $CSD_{o,max}(3)$ |
| + | - | $CSD_{o,max}(3)$ | $CSD_{o,max}(2)$ |
| - | + | $CSD_{o,max}(3)$ | $CSD_{o,max}(2)$ |
| - | - | $CSD_{o,max}(2)$ | $CSD_{o,max}(3)$ |

The difference is taken between $Max_o1$ and $Max_o2$, then the sign is determined:

$$D_o3=\mathrm{sgn}[Max_o1- [\mathrm{sgn}Max_o1 \cdot \mathrm{sgn}Max_o2] \cdot Max_o2]$$

The sign of $D_o3$ will determine the maximum $CSD_{o,max}(j)$, $Max_o$, according to Table 7 below:

Table 7

| $D_o3$ | $\mathrm{sgn}Max_o1$ | $Max_o$ |
|---|---|---|
| + | + | $Max_o1$ |
| + | - | $Max_o2$ |
| - | + | $Max_o2$ |
| - | - | $Max_o1$ |

The difference is taken between $Min_o1$ and $Min_o2$, then the sign is determined:

$$D_o4=\mathrm{sgn}[Min_o1-[\mathrm{sgn}Min_o1\cdot\mathrm{sgn}Min_o2] \cdot Min_o2]$$

The sign of $D_o4$ will determine the minimum $CSD_{o,max}(j)$, $Min_o$, according to Table 8 below:

Table 8

| $D_o4$ | $\mathrm{sgn}Min_o1$ | $Min_o$ |
|---|---|---|
| + | + | $Min_o2$ |
| + | - | $Min_o1$ |
| - | + | $Min_o1$ |
| - | - | $Min_o2$ |

$Max_o$ and $Min_o$ are the maximum and minimum character soft decisions of the set $\{CSD_{o,max}(j),j=0,...,3\}$. The column indices of these maximum and minimum character soft decisions, $j_{o,max}$ and $j_{o,min}$, indicate the positions of $Max_o$ and $Min_o$. The column indices, $j_{o,2}$ and $j_{o,3}$, indicate the positions of the remaining two character soft decisions.

The NR decoder 20 then identifies the GF(4) character, (GF(4)={a, b, c, d}), $Char_{e,max}(j)$ and $Char_{o,max}(j)$, corresponding to each $CSD_{e,max}(j)$ and $CSD_{o,max}(j)$ using two bits, $a_0$ and $a_1$. The bits $a_0$ and $a_1$ are determined from $HD_e(1,j)$, $HD_e(2,j)$, $HD_e(3,j)$ and $HD_o(1,j)$, $HD_o(2,j)$, $HD_o(3,j)$ based on the following 16 possible interpretations of the 4 characters:

Table 9

| Interpretations for GF(4) characters | | | | | | | | | | | | | | | |
|---|---|---|---|---|---|---|---|---|---|---|---|---|---|---|---|
| Even Interpretations | | | | | | | | Odd Interpretations | | | | | | | |
| a | | b | | c | | d | | a | | b | | c | | d | |
| 0 | 1 | 1 | 0 | 1 | 0 | 1 | 0 | 1 | 0 | 0 | 1 | 0 | 1 | 0 | 1 |

Table 9   (continued)

| Interpretations for GF(4) characters | | | | | | | | | | | | | | | |
|---|---|---|---|---|---|---|---|---|---|---|---|---|---|---|---|
| Even Interpretations | | | | | | | | Odd Interpretations | | | | | | | |
| a | | b | | c | | d | | a | | b | | c | | d | |
| 0 | 1 | 1 | 0 | 0 | 1 | 0 | 1 | 0 | 1 | 1 | 0 | 0 | 1 | 0 | 1 |
| 0 | 1 | 0 | 1 | 1 | 0 | 0 | 1 | 0 | 1 | 0 | 1 | 1 | 0 | 0 | 1 |
| 0 | 1 | 0 | 1 | 0 | 1 | 1 | 0 | 0 | 1 | 0 | 1 | 0 | 1 | 1 | 0 |
| Notes:　1. The two interpretations for each character are complements of each other.<br>2. The odd and even interpretations are identical except the first row is complemented. | | | | | | | | | | | | | | | |

Table 10

| $a_0(j)$ | $a_1(j)$ | $Char_{e/o,max}(j)$ |
|---|---|---|
| 0 | 0 | a |
| 0 | 1 | b |
| 1 | 1 | c |
| 1 | 0 | d |

Even

$$a_0(j)=HD_e(2,j)\oplus HD_e(3,j)$$

$$a_1(j)=HD_e(1,j)\oplus HD_e(2,j)$$

Odd

$$a_0(j)=HD_o(2,j)\oplus HD_o(3,j)$$

$$a_1(j)=HD_o(1,j)\oplus HD_o(2,j)$$

The four columns of the even hard decision array may be used to form four even Quadracodewords ($QCW_e$), and likewise the four columns of the odd hard decision array may be used to form four odd Quadracodewords ($QCW_o$). The process for forming the four even Quadracodewords will be given first, followed by the process for forming the four odd Quadracodewords. The four even Quadracodewords may be formed by specifying pairs of GF(4) characters corresponding to $CSD_{e,max}(j)$ for two values of j. If all combination pairs of two $CSD_{e,max}(j)$ were considered from the possible four $CSD_{e,max}(j)$, there would be six unique pairs:

$$[Char_{e,max}(j_{e,max}), Char_{e,max}(j_{e,2})]$$

$$[Char_{e,max}(j_{e,max}), Char_{e,max}(j_{e,3})]$$

$$[Char_{e,max}(j_{e,max}), Char_{e,max}(j_{e,min})]$$

$$[Char_{e,max}(j_{e,2}), Char_{e,max}(j_{e,3})]$$

$$[\text{Char}_{e,max}(j_{e,2}), \text{Char}_{e,max}(j_{e,min})]$$

$$[\text{Char}_{e,max}(j_{e,3}), \text{Char}_{e,max}(j_{e,min})]$$

The NR decoder 20 may eliminate all pairs with $\text{Char}_{e,max}(j_{e,min})$ except the pair $[\text{Char}_{e,max}(j_{e,max}), \text{Char}_{e,max}(j_{e,min})]$. The four remaining pairs will then be:

$$[\text{Char}_{e,max}(j_{e,max}), \text{Char}_{e,max}(j_{e,2})]$$

$$[\text{Char}_{e,max}(j_{e,max}), \text{Char}_{e,max}(j_{e,3})]$$

$$[\text{Char}_{e,max}(j_{e,max}), \text{Char}_{e,max}(j_{e,min})]$$

$$[\text{Char}_{e,max}(j_{e,2}), \text{Char}_{e,max}(j_{e,3})]$$

If the two characters are the same, then it is known that the QCW belongs to the subcode, Q* (Q* is defined to be the subcode where all the characters of the QCW are the same), and the other two characters are the same as the specified characters. If the two characters are different, then the remaining two characters are known and their assignment to the two bit positions needs to be determined. The NR decoder 20 creates the even QCWs for each of the four pairs listed above by encoding the QCW according to the encoder noted below. Also, the NR decoder 20 assigns $\text{Char}(0)=(c_0,c_1)$ to the GF(4) character with smaller j and $\text{Char}(1)=(c_2,c_3)$ to the other GF(4) character:

Table 11

| GF(4) Char | Char(0) | | Char(1) | |
|---|---|---|---|---|
| | $c_0$ | $c_1$ | $c_2$ | $c_3$ |
| a | 0 | 0 | 0 | 0 |
| b | 0 | 1 | 0 | 1 |
| c | 1 | 1 | 1 | 1 |
| d | 1 | 0 | 1 | 0 |

The remaining two GF(4) characters, Char(2) and Char(3) are determined from the two input characters Char (0) and Char(1) :

$$b_0 = c_0 \oplus c_1 \oplus c_3$$

$$b_1 = c_0 \oplus c_2 \oplus c_3$$

$$b_2 = c_1 \oplus c_2 \oplus c_3$$

$$b_3 = c_0 \oplus c_1 \oplus c_2$$

Table 12

| GF(4) Char | Char(2) | | Char(3) | |
|---|---|---|---|---|
| | $b_0$ | $b_1$ | $b_2$ | $b_3$ |
| a | 0 | 0 | 0 | 0 |
| b | 0 | 1 | 0 | 1 |
| c | 1 | 1 | 1 | 1 |
| d | 1 | 0 | 1 | 0 |

The two column indices of Char(0) and Char(1) may be represented as two bits:

Table 13

| j | $j_{b0}$ | $j_{b1}$ |
|---|---|---|
| 0 | 0 | 0 |
| 1 | 0 | 1 |
| 2 | 1 | 1 |
| 3 | 1 | 0 |

Now a new variable, swap, is defined as follows:

$$swap = (j_{b0} \oplus j'_{b0}) \oplus (j_{b1} \oplus j'_{b1})$$

where the bit pair $j_{b0}$, $j_{b1}$ corresponds to the column index of Char(0) and $j'_{b0}, j'_{b1}$ corresponds to the column index of Char(1). The four characters in the Quadracodeword are known and their column indices need to be determined. Since the column indices of Char(0) and Char(1) are already known, there are two open slots to fill since there are a total of four columns. The column indices of the remaining two GF(4) characters will be determined by the variable swap:

If swap=1, put Char(2) into the open slot with smaller index j. Put Char(3) into the other open slot.
If swap=0, put Char (2) into the open slot with larger index j. Put Char(3), into the other open slot.

Similarly the above process is repeated for the four odd Quadracodewords. The four odd Quadracodewords will be formed by specifying pairs of GF(4) characters corresponding to $CSD_{o,max}(j)$ for two values of j. By taking all combinations of two $CSD_{o,max}(j)$ from the possible four $CSD_{o,max}(j)$, there will be six unique pairs:

$$[Char_{o,max}(j_{o,max}), Char_{o,max}(j_{o,2})]$$

$$[Char_{o,max}(j_{o,max}), Char_{o,max}(j_{o,3})]$$

$$[Char_{o,max}(j_{o,max}), Char_{o,max}(j_{o,min})]$$

$$[Char_{o,max}(j_{o,2}), Char_{o,max}(j_{o,3})]$$

$$[Char_{o,max}(j_{o,2}), Char_{o,max}(j_{o,min})]$$

$$[Char_{o,max}(j_{o,3}), Char_{o,max}(j_{o,min})]$$

All pairs with $Char_{o,max}(j_{o,min})$ are eliminated except the pair $[Char_{o,max}(j_{o,max}), Char_{o,max}(j_{o,min})]$. The four remaining pairs will then be:

$$[Char_{o,max}(j_{o,max}), Char_{o,max}(j_{o,2})]$$

$$[Char_{o,max}(j_{o,max}), Char_{o,max}(j_{o,3})]$$

$$[Char_{o,max}(j_{o,max}), Char_{o,max}(j_{o,min})]$$

$$[Char_{o,max}(j_{o,2}), Char_{o,max}(j_{o,3})]$$

The NR decoder 20 creates the odd Quadracodewords for each of the four pairs listed above by doing the following. First, the QCW is encoded according to the encoder below, assigning Char (0) = $(c_2, c_3)$ to the GF(4) character with smaller j and assigning Char(1) = $(c_0, c_1)$ to the other GF(4) character:

Table 14

| GF(4) Char | Char(1) | | Char(0) | |
|---|---|---|---|---|
| | $c_0$ | $c_1$ | $c_2$ | $c_3$ |
| a | 0 | 0 | 0 | 0 |
| b | 0 | 1 | 0 | 1 |
| c | 1 | 1 | 1 | 1 |
| d | 1 | 0 | 1 | 0 |

For the odd QCW, the encoding is the same as for the even QCW except that the two input characters are swapped.

The remaining two GF(4) characters, Char(2) and Char(3) are determined from the two input characters Char(0) and Char(1) :

$$b_0 = c_0 \oplus c_1 \oplus c_3$$

$$b_1 = c_0 \oplus c_2 \oplus c_3$$

$$b2 = c_1 \oplus c_2 \oplus c_3$$

$$b3 = c_0 \oplus c_1 \oplus c_2$$

Table 15

| GF(4) Char | Char(2) | | Char(3) | |
|---|---|---|---|---|
| | $b_0$ | $b_1$ | b2 | b3 |
| a | 0 | 0 | 0 | 0 |
| b | 0 | 1 | 0 | 1 |
| c | 1 | 1 | 1 | 1 |
| d | 1 | 0 | 1 | 0 |

The two column indices of Char(0) and Char(1) are represented as two bits:

Table 16

| j | $j_{b0}$ | $j_{b1}$ |
|---|---|---|
| 0 | 0 | 0 |
| 1 | 0 | 1 |
| 2 | 1 | 1 |
| 3 | 1 | 0 |

Now a new variable, swap, is defined as follows:

$$swap= (j_{b0} \oplus j'_{b0}) \oplus (j_{b1} \oplus j'_{b1})$$

where the bit pair $j_{b0}$, $j_{b1}$ corresponds to the column index of Char(0) and $j'_{b0}, j'_{b1}$ corresponds to the column index of Char(1). The four characters in the Quadracodeword are known and their column indices are next determined. Since the column indices Char(1) and Char(0) are already known, there are two open slots to fill since there are a total of four columns. The column indices of the remaining two GF(4) characters will be determined by the variable swap:

If swap=1, put Char(2) into the open slot with smaller index j. Put Char(3) into the other open slot.
If swap=0, put Char(2) into the open slot with larger index j. Put Char(3) into the other open slot.

For each of the four even Quadracodewords the character soft decisions and hard decisions of characters, Char(2) and Char(3) must be determined. If these two characters were not determined in Step 7, the CSD has to be computed.

For new characters, the NR decoder 20 determines k' from the $j^{th}$ column of $HD_0$ (from Step 5) and $HD_{new}$, a 4x1 array representing an interpretation for the new character taken from Table 9:

$$Comp1=HD_0(1,j) \oplus HD_{new}(1)$$

$$Comp2=HD_0(2,j) \oplus HD_{new}(2)$$

$$Comp3=HD_0(3,j) \oplus HD_{new}(3)$$

Table 17

| Dif0 | Dif1 | k' |
|---|---|---|
| 0 | 0 | 0 |
| 1 | 0 | 1 |
| 1 | 1 | 2 |
| 0 | 1 | 3 |
| Note 1: Interpretation taken from Step 7 ($HD_{new}(k,j)$ can be either one of the two complementary interpretations shown in Table 9). Note 2: j=column corresponding to Char(2) or Char(3). | | |

The CSD is calculated for the new GF(4) character in position j of the $n^{th}$ even Quadracodeword (n=0,1,2,3):

$$CSD_n(j)=CSD_{o,max}(j) - [sgnSD(0,j)] \cdot [sgnSD(k',j)] \cdot 2 \cdot SD(k',j)$$

The hard decision is determined for the new GF(4) character:

$$HD_n(k,j) = \begin{cases} \overline{HD_o(k,j)}, & k = k \\ HD_o(k,j), & k \neq k \end{cases}$$

If $[sgnCSD_n(j)]\neq[sgnSD(0,j)]$

$$HD_n(:,)=\overline{HD_n(:,j)},(HD_n(:,j)\text{denotes a column of HD}$$

The character soft decision, $CSD_n(j),n=0,...,3$ and hard decision, $HD_n(k,j)$, for each character making up the Quadracodeword is now known.

For each of the four odd Quadracodewords the character soft decisions and hard decisions of characters, Char(2) and Char(3), must be determined. If these two characters were not determined above, the CSD has to be computed.

Also for new characters, the NR decoder 20 determines k' from the $j^{th}$ column of $HD_e$ (from Step 5) and $HD_{new}$, a 4x1 array representing an interpretation for the new character taken from Table 9:

$$Comp1=HD_e(1,j)\oplus HD_{new}(1)$$

$$Comp2=HD_e(2,j)\oplus HD_{new}(2)$$

$$Comp3=HD_e(3,j)\oplus HD_{new}(3)$$

$$Dif0=Comp1\oplus Comp2$$

$$Dif1=Comp2\oplus Comp3$$

Table 18

| Dif0 | Dif1 | k' |
|---|---|---|
| 0 | 0 | 0 |
| 1 | 0 | 1 |
| 1 | 1 | 2 |
| 0 | 1 | 3 |
| Note 1: Interpretation taken from Step 7 ($HD_{new}(k,j)$ can be either one of the two complementary interpretations shown in Table 9). Note 2: j=column corresponding to Char(2) or Char(3). | | |

The CSD is calculated for the new GF(4) character in position j of the $n_{th}$ even Quadracodeword (n=4,5,6,7):

$$CSD_n(j)=CSD_{e,max}(j)-[sgnSD(0,j)] \cdot [sgnSD(k',j)]\cdot 2\cdot SD(k',j)$$

The hard decision for the new GF(4) character:

$$HD_n(k,j) = \begin{cases} \overline{HD_e(k,j)}, k = k'' \\ HD_e(k,j), k \neq k' \end{cases}$$

If [sgnCSD$_n$(j)$\neq$[sgnSD(0,j)]

$$HD_n(:,j) = \overline{HD_n(:,j}$$

The character soft decision, CSD$_n$(j),n=4,...,7 and hard decision, HD$_n$(k,j), for each character making up the Quadracodeword is now known.

The NR decoder 20 determines if the four even and four odd Quadracodewords are Nordstrom-Robinson codewords by computing NRC. First, the NR decoder 20 checks whether the Quadracodeword is in the subcode, Q*:

$$QC=(C_0 \oplus C_2) \mid (C_1 \oplus C_3)$$

If QC=0 then the QCW is in Q*; otherwise the QCW is not in Q*.

Next, the NR decoder 20 determines the top row parity of the Quadracodeword.

$$TRP= (HD_n(0,0) \oplus HD_n(0,1)) \oplus (HD_n(0,2) \oplus HD_n(0,3))$$

Then, the NR decoder 20 determines whether or not the QCW is a Nordstrom-Robinson codeword.

If n=0, 1, 2, 3 (even code): OE=0
If n=4, 5, 6, 7 (odd code): OE=1

$$NRC=(OE \oplus QC) \oplus TRP$$

Table 19

| OE | QC | TRP | NRC |
|----|----|-----|-----|
| 0  | 0  | 0   | 0   |
| 0  | 0  | 1   | 1   |
| 0  | 1  | 0   | 1   |
| 0  | 1  | 1   | 0   |
| 1  | 0  | 0   | 1   |
| 1  | 0  | 1   | 0   |
| 1  | 1  | 0   | 0   |
| 1  | 1  | 1   | 1   |

The NR decoder 20 calculates the metrics, NRSD(n),n=0,...,3 for the four even Nordstrom-Robinson codewords.
If NRC = 0

$$NRSD(n)=CSD_n(0)+[sgnCSD_n(0)] \cdot [sgnCSD_n(1)] \cdot CSD_n(1)$$

$$+ [sgnCSD_n(0)] \cdot [sgnCSD_n(2)] \cdot CSD_n(2)$$

$$+ [\text{sgnCSD}_n(0)] \cdot [\text{sgnCSD}_n(3) \cdot \text{CSD}_n(3)$$

Else if NRC=1

The MinChar is set equal to the column index, $j_{e,min}$. The value of $\text{sgn}[\text{CSD}_n(\text{MinChar})]$ is flipped and the metric, NRSD(n) is calculated.

$$\text{NRSD}(n) = \text{CSD}_n(0) + [\text{sgnCSD}_n(0)] \cdot [\text{sgnCSD}_n(1)] \cdot \text{CSD}_n(1)$$

$$+ [\text{sgnCSD}_n(0)] \cdot [\text{sgnCSD}_n(2)] \cdot \text{CSD}_n(2)$$

$$+ [\text{sgnCSD}_n(0)] \cdot [\text{sgnCSD}_n(3)] \cdot \text{CSD}_n(3)$$

$$\text{HD}_n(:,\text{MinChar}) = \overline{\text{HD}_n(:,\text{MinChar}}$$

At Step 11b, the metrics, NRSD(n),n=4,...,7 are calculated for the four odd Nordstrom-Robinson codewords. If NRC = 0

$$\text{NRSD}(n) = \text{CSD}_n(0) + (\text{sgnCSD}_n(0)] \cdot [\text{sgnCSD}_n(1)] \cdot \text{CSD}_n(1)$$

$$+ [\text{sgnCSD}_n(0)] \cdot [\text{sgnCSD}_n(2)] \cdot \text{CSD}_n(2)$$

$$+ [\text{sgnCSD}_n(0)] \cdot [\text{sgnCSD}_n(3)] \cdot \text{CSD}_n(3)$$

Else if NRC=1

The MinChar is set equal to the column index, $j_{o,min}$. The value of $\text{sgn}[\text{CSD}_n(\text{MinChar})]$ is flipped and the metric, NRSD(n) is calculated.

$$\text{NRSD}(n) = \text{CSD}_n(0) + [\text{sgnCSD}_n(0)] \cdot [\text{sgnCSD}_n(1)] \cdot \text{CSD}_n(1)$$

$$+ [\text{sgnCSD}_n(0)] \cdot [\text{sgnCSD}_n(2)] \cdot \text{CSD}_n(2)$$

$$+ [\text{sgnCSD}_n(0)] \cdot [\text{sgnCSD}_n(3)] \cdot \text{CSD}_n(3)$$

$$\text{HD}_n(:,\text{MinChar}) = \overline{\text{HD}_n(:,\text{MinChar}}$$

Finally, the value of n is found with the maximum absolute value of NRSD(n), and decode to the hard decision, $\text{HD}_n(k,j)$, k=0,...,3, j=0,...,3.

Based on the foregoing process, an NR codeword is obtained and used to decode the SD matrix 600.

While particular elements, embodiments and applications of the present invention have been shown and described, it will be understood, that the invention is not limited thereto since modifications may be made by those skilled in the art, particularly in light of the foregoing teachings. It is, therefore, contemplated by the appended claims to cover such modifications as incorporate those features which come within the spirit and scope of the invention.

**Claims**

1. A method for decoding a received data block encoded with a Nordstrom-Robinson (NR) codeword, the method comprising the steps of:

    dividing a received data block into data subsets;
    calculating a maximum confidence quadracodeword (QCW) character for each data subset to form a set of maximum confidence QCW characters;

determining a set of maximum confidence quadracodewords based on said set of maximum confidence QCW characters; and

identifying an NR codeword based on said set of maximum confidence QCW characters.

**2.** The method of claim 1, wherein said calculating step further comprises the steps of:

mapping at least one unique character bit string to each QCW character;

obtaining a dot product of each data subset and each character bit string; and

comparing the dot products to identify a maximum confidence character representing the QCW character most likely to correspond to the data subset.

**3.** The method of claim 1, wherein said calculating step further comprises the steps of:

determining correlation weights between one data subset and at least two quadracodeword characters; and

selecting the quadracodeword character having a maximum correlation weight to be a member of the set of QCW characters.

**4.** The method of claim 1, wherein said calculating step further comprises the step of:

choosing a maximum confidence QCW character for a data subset, the maximum confidence QCW character having a maximum correlation to the data subset.

**5.** The method of claim 1, further comprising the step of:

forming a 4x4 soft-decision matrix from analog data values in the received data block, wherein each column of the 4x4 soft decision matrix constitutes one of said data subsets.

**6.** The method of claim 1, wherein said determining step further comprises the steps of:

selecting at least one subset of characters from the set of characters; and

identifying a unique quadracodeword corresponding to the subset of characters.

**7.** The method of claim 1, wherein said determining step further comprises the steps of:

selecting multiple pairs of characters from said set of maximum confidence quadracodeword (QCW) characteristics; and

for each character pair, selecting a unique corresponding quadracodeword to form the set of quadracodewords.

**8.** The method of claim 1, further comprises the steps of:

obtaining a correlation weight for each available QCW character, the correlation weight identifying a degree of correlation between an associated QCW character and an associated data subset.

**9.** The method of claim 1, further comprising the steps of:

assigning the characters from the set of QCW characters to positions in each quadracodeword in the set of quadracodewords based on the position of corresponding data subsets in the received data block.

**10.** The method of claim 1, further comprising the steps of:

identifying at least one NR codeword corresponding to each quadracodeword in said set of maximum confidence quadracodewords to form a set of maximum confidence NR codewords; and

selecting a single NR codeword from said set of NR codewords to decode the received data block.

**11.** The method of claim 10, wherein said identifying step further comprises the steps:

constructing a binary codeword for each QCW based on a correlation between QCW characters in the QCW and corresponding data subsets.

**12.** The method of claim 10, wherein said identifying step further comprises the steps:

generating character interpretation map uniquely associating each QCW character with at least one character bit string;

calculating a correlation factor between a character bit string associated with each QCW character in a QCW and an associated data subset; and

selecting a one of said character bit strings to add to the NR codeword based on the correlation factors.

13. The method of claim 1, further comprising:

converting each quadracodeword in the set of quadracodewords to a binary interpretation of the quadracodeword to form a binary interpretation of said NR codeword.

14. The method of claim 10, further comprising:

mapping each quadracodeword in the set of quadracodewords to a set of binary codewords; and
correct each binary codeword to form a set of NR codewords, wherein the number of NR codewords equals the number of quadracodewords.

15. The method of claim 1, further comprising:

converting the set of quadracodewords to NR codewords based on a parity of binary interpretations of the quadracodewords.

Figure 1

Encode Information Data with NR Codeword to Form
Encoded Data Block — 200

Transmit Encoded Data Block — 202

Receive Data Blocks with Channel Noise — 204

Identify the Maximum Confidence QCW Characters
for Subsets of the Received Data Block that Most
Likely Correspond to the Subsets — 206

Identify Maximum Confidence Quadracodewords
that Most Likely Correspond to Subset of NR
Codewords Containing NR Codeword Encoded in
the Received Data Block — 208

Obtain Unique Subset of NR Codewords Mapped to
Identified QCWs — 210

Identify NR Codeword from Obtained Subset that
Most Likely Corresponds to the NR Codeword
Encoded in the Received Data Block — 212

Figure 2

Generate a Matrix of Soft Decision Received Data Values — 300

Obtain Map of Binary Interpretation Values for Each Quadracodeword Character — 302

Calculate Maximum Confidence Characters for Each Column of SD Matrix and Store in Maximum Confidence Character Table — 304

Determine Set of Maximum Confidence Quadracodewords Based on Maximum Confidence Character Pairs — 306

Assign Nordstrom-Robinson Codeword to Each Maximum Confidence Quadracodeword Based on Correlation Between Quadracodewords and SD Matrix — 308

Select Maximum Confidence NRCW Based on Correlation Between NRCW and SD Matrix — 310

**Figure 3**

EP 1 175 012 A2

|  | Even | | | | Odd | | | |
|---|---|---|---|---|---|---|---|---|
| 1 | a | a | a | a | a | a | a | a |
| 2 | a | b | c | d | a | b | d | c |
| 3 | a | c | d | b | a | c | b | d |
| 4 | a | d | b | c | a | d | c | b |
| 5 | b | a | d | c | b | a | c | d |
| 6 | b | b | b | b | b | b | b | b |
| 7 | b | c | a | d | b | c | d | a |
| 8 | b | d | c | a | b | d | a | c |
| 9 | c | a | b | d | c | a | d | b |
| 10 | c | b | d | a | c | b | a | d |
| 11 | c | c | c | c | c | c | c | c |
| 12 | c | d | a | b | c | d | b | a |
| 13 | d | a | c | b | d | a | b | c |
| 14 | d | b | a | c | d | b | c | a |
| 15 | d | c | b | a | d | c | a | b |
| 16 | d | d | d | d | d | d | d | d |

402, 404, 400

406  407  408  409

**Figure 4**

*500*

| Even Interpretations | | | | | | | | Odd Interpretations | | | | | | | |
|---|---|---|---|---|---|---|---|---|---|---|---|---|---|---|---|
| a | | b | | c | | d | | a | | b | | c | | d | |
| 0 | 1 | 1 | 0 | 1 | 0 | 1 | 0 | 1 | 0 | 0 | 1 | 0 | 1 | 0 | 1 |
| 0 | 1 | 1 | 0 | 0 | 1 | 0 | 1 | 0 | 1 | 1 | 0 | 0 | 1 | 0 | 1 |
| 0 | 1 | 0 | 1 | 1 | 0 | 0 | 1 | 0 | 1 | 0 | 1 | 1 | 0 | 0 | 1 |
| 0 | 1 | 0 | 1 | 0 | 1 | 1 | 0 | 0 | 1 | 0 | 1 | 0 | 1 | 1 | 0 |

*502*        *504*

*506  507  508  509  510  511  512  513  526  527  528  529  530  531  532  533*

**Figure 5**

$$\begin{bmatrix} sd0 & sd4 & sd8 & sd12 \\ sd1 & sd5 & sd9 & sd13 \\ sd2 & sd6 & sd10 & sd14 \\ sd3 & sd7 & sd11 & sd15 \end{bmatrix}$$

601    602    603    604

**Figure 6**

700

|  | Col$_1$ | Col$_2$ | Col$_3$ | Col$_4$ |
|---|---|---|---|---|
| Even Characters | Char(a) 702 | Char(b) 703 | Char(c) 704 | Char(a) 705 |
|  | MCDP$_1$=1 722 | MCDP$_2$=7 723 | MCDP$_3$=4 724 | MCDP$_4$=9 725 |
| Odd Characters | Char(b) 706 | Char(b) 707 | Char(a) 708 | Char(d) 709 |
|  | MCDP$_1$=10 726 | MCDP$_2$=1 727 | MCDP$_3$=4 728 | MCDP$_4$=2 729 |

**Figure 7**

*800*

*834*
*838*

| Character Pairs | Maximum Confidence Quadracodewords | |
|---|---|---|
| x b x a | c b d a | 4 Even QCWs |
| 822 | 802 | |
| x x c a | b d c a | |
| 823 | 803 | |
| a x x a | a a a a | |
| 824 | 804 | |
| x b c x | a b c d | |
| 825 | 805 | |
| b x a x | b d a c | 4 Odd QCWs |
| 826 | 806 | |
| b x x d | b a c d | |
| 827 | 807 | |
| b b x x | b b b b | |
| 828 | 808 | |
| x x a d | c b a d | |
| 829 | 809 | |

*840*
*836*

*830*        *832*

**Figure 8**

900

909

QCW_n Interpretation

903

QCW_2 Interpretation

902

920

922

QCW_1 Interpretation

| c | b | d | a | 914 |
|---|---|---|---|---|
| 1 | 0 | 0 | 1 | 916 |
| 0 | 0 | 1 | 1 | |
| 1 | 1 | 1 | 1 | |
| 0 | 1 | 0 | 1 | 943 |
| 4.9 | 7.0 | 1.2 | 9.0 | 918 |

940

924

930    931  941  932  942  933

Figure 9

Figure 10

Figure 11

Multiply One Character Bit String from Bit String Pair with Corresponding Column from SD Matrix — 1202

If Dot Product of Character Bit String and SD Matrix Column is Non-Negative, Store Character Bit String in QCW Interpretation Table — 1204

If Dot Product of Character Bit String and SD Matrix Column is Negative, Store Complement of Character Bit String in QCW Interpretation Table — 1206

Repeat for Each Character in QCW — 1208

Repeat for Each QCW — 1210

For Even QCW, If Characters All the Same, First Row Parity is Even; Otherwise First Row Parity is Odd — 1212

Complement Character Bit String with Lowest Correlation Factor and Negative Confidence Value of Character — 1214

For Odd QCW, If Characters All the Same, First Row Parity is Odd; Otherwise First Row Parity is Even — 1216

Complement Character Bit String with Lowest Correlation Factor and Negate Confidence Value of Character — 1218

Select NR Codeword with Maximum Confidence — 1220

**Figure 12**

**Figure 13**